# EUROPEAN PATENT SPECIFICATION

(11) **EP 3 698 149 B1**
(45) Date of publication and mention of the grant of the patent: **25.11.2026**
(21) Application number: 18808051.9
(22) Date of filing: 15.10.2018
(51) Int. Cl.: G01R 31/08, G01R 31/11

(54) **FAULT MAPPING METHOD AND SYSTEM FOR POWER DISTRIBUTION NETWORKS**
VERFAHREN UND SYSTEM ZUR FEHLERZUORDNUNG FÜR STROMVERSORGUNGSNETZE
PROCÉDÉ ET SYSTÈME DE CARTOGRAPHIE DE DÉFAUTS POUR RÉSEAUX DE DISTRIBUTION D'ÉNERGIE

(30) Priority: 16.10.2017 GB 201716959
(43) Date of publication of application: 26.08.2020
(73) Proprietor: EA Technology Limited, Chester, Cheshire CH1 6ES (GB)
(72) Inventor: LEES, Michael Ian, Capenhurst, Chester CH1 6ES (GB); ROBERTS, David, Capenhurst, Chester CH1 6ES (GB)
(74) Representative: Prichard, Leslie Stephen
(86) International application number: PCT/GB2018/052957
(87) International publication number: WO 2019/077322

(56) References cited:
- EP-A1- 2 221 626
- US-A1- 2009 289 637
- US-A1- 2016 011 252

## Description

### TECHNICAL FIELD OF THE INVENTION

This invention relates to a fault mapping method and system for power distribution networks. More particularly, this invention relates to an impedance-based cable fault mapping method and system for low voltage (LV) networks. In the event of a fault occurring on a network which can be detected and the type of fault classified from known impedance-based techniques, the present invention enabling the fault to be located by providing at least one geoschematic representation of the network having one or more fault impedance values thereon. Use of the present enabling faults on networks to be located rapidly to minimise customer interruptions.

### BACKGROUND

Several impedance-based fault location techniques are known in the art. These generally involve the use of various intelligent electronic devices which can be permanently or temporarily installed on a network and which are capable of recording, capturing and analysing voltage and current waveforms during network faults, including transitory and intermittent faults.

These impedance-based techniques have proven popular since the fault impedance can be estimated from the voltage and current measurements obtained at just one point on the network (typically obtained in the substation). Presently, this fault impedance can then combined with the network's particular topology, line impedance and load models to estimate how the voltage and current can be propagated with the objective of finding and communicating an accurate "distance to fault" to a field operative to then pinpoint the fault and restore the supply in the shortest time possible.

These known impedance-based methods however require specialist operator intervention and processing to translate the impedance information during network faults by determining cable types and lengths (and hence impedance) and the cable route working away from the substation and then either marking the fault on a cable plan or sending a distance to fault (in metres) from the substation to the field operative or team involved with pinpointing the fault. An added complication of communicating the distance to fault obtained via known impedance-based methods is that, on branched networks with different cable types, the fault impedance may relate to different distances from the substation depending on the branch in which the fault has occurred.

These known impedance-based methods also suffer from other disadvantages. Specialist operator intervention is needed when taking the information communicated from the substation, interpreting this and estimating the distance to fault for the possible different branches. This processing therefore takes time, and the estimated distance to fault relating to the possible different locations of the fault is often communicated to the field operative sometime after the fault has occurred.

In addition, this processing is required for each fault record as it is registered. A subsequent fault on the same cable in the network requires the process to be repeated as though it were a different cable. Furthermore, these techniques are strewn with errors and assumptions in the conversion of the fault impedance to a distance to fault in metres, and a field operative may then need to spend further time locating the precise fault position through subsequent pinpointing activities.

Therefore, a need exists for fault mapping method and system which provides a geoschematic representation of the network having one or more fault impedance values superimposed thereon, and which alleviates or reduces some of the problems outlined above. A need exists for an impedance-based cable fault mapping method and system for LV networks that does away with the requirement for individual processing and analysis of the cable route, and instead directly maps the fault location from an estimation of the fault impedance.

Examples of prior art arrangements are disclosed in US 2016/0011252 A1 (Kang, et al.) and EP 2 221 626 A1 (ABB Research Ltd). US 2009/289637 A1 shows a method for monitoring the impedance of underground power line cable segments in a power distribution network, where cable segments with change in impedance are marked.

It is an object of the present invention to provide an impedance-based cable fault mapping method and system for LV networks. It is a further object of the present invention to provide means for representing the location of a fault once the fault impedance has been estimated by providing a geoschematic representation of the network having one or more fault impedance values thereon. Since the geoschematic representation of the network has been pre-prepared, once the fault impedance has been estimated, the location of the fault can be communicated to field operatives for fault clearing in very short timescales, or in near real time.

### SUMMARY OF THE INVENTION

The present invention is described herein and in the claims.

According to a first aspect of the present invention there is provided a fault mapping method for one or more outgoing cables of a power distribution network, the method comprising the steps of:
obtaining a geoschematic cable record of the power distribution network;
marking a plurality of intermediate cumulative fault impedance markings adjacent to the route of the one or more cables on the geoschematic cable record for each of the cable branches of the network; and
supplying the marked cable record to a field operative having access to an estimated fault impedance of a cable fault, the estimated fault impedance being obtained from voltage and current measurements from a single point on the network, and comparing by the field operative the estimated fault impedance against the respective plurality of fault impedance markings on the cable branches of the network to locate the cable fault.

An advantage of the present invention is that the one or more fault impedance markings on the marked cable record allow the cable fault to be located rapidly and reliably from the estimated fault impedance without any further processing.

Preferably, the marked cable record is a geoschematic cable record which conveys data representative of the one or more cables of the network, the data being selected from the group consisting, but not limited to, any one of the following: individual branches of the network and the location and route of the branches, size and type of cables, cable burial depth, cable joints, substations, circuit protection devices and ratings, link boxes, reclose units, fault management and monitoring devices, road and street names and the like.

Further preferably, the marked cable record is a scaled spider diagram and/or digitised cable record from a graphical information system and/or mapping layer and/or some other geoschematic or graphical layer.

In use, the step of marking one or more intermediate cumulative fault impedance markings adjacent to the route of the one or more cables on a digitised cable record may further comprise the steps of:
selecting one cable branch of the network;
determining the length and type of cable for the branch;
calculating the phase to earth loop impedance of the cable branch based on the preceding step; and
recording a cumulative impedance for the branch on a first marked cable record.

Preferably, the step of marking one or more intermediate cumulative fault impedance markings adjacent to the route of the one or more cables on a digitised cable record further comprises the steps of:
selecting one cable branch of the network;
determining the length and type of cable for the branch;
calculating the phase to neutral loop impedance of the cable branch based on the preceding step; and
recording a cumulative impedance for the branch on a second marked cable record.

Further preferably, the method further comprising the step of:
repeating the steps of selecting, determining, calculating and recording for all of the cable branches of the network.

In use, the method may further comprise the step of:
marking all of the cable branches of the network with intermediate impedance markings at a desired resolution on the first and second marked cable records.

Preferably, the desired resolution of the intermediate impedance markings is between around 5mΩ to around 20mQ.

Further preferably, the method further comprising the step of:
making either of the first and second marked cable records available to the field operative dependent upon the type of cable fault on the network.

In use, the step of supplying the marked cable record to a field operative having access to an estimated fault impedance of a cable fault may further comprise the step of:
alerting the field operative via a push or in-app notification or alert and/or short message service (SMS) text message and/or e-mail notification to a mobile communications device.

Preferably, the mobile communications device is selected from the group consisting, but not limited to, any one of the following: smartphone, tablet computer, handheld computer, personal digital assistant, media player, desktop computer, notebook, virtual reality headset, smart watch, and any other digital media consumption device and the like.

Further preferably, the one or more intermediate cumulative fault impedance markings comprise numeric and/or graphical elements.

In use, the field operative may compare the estimated fault impedance against the respective one or more intermediate cumulative fault impedance markings on the cable branches to locate the cable fault.

Preferably, the estimated fault impedance is obtained from voltage and current measurements of at least one point on the network.

Further preferably, the estimated fault impedance is determined using an impedance-based fault location method.

In use, the cable fault may be a Phase to Earth fault (P-E) or Phase to Phase fault (P-P) or Phase to Phase to Earth fault (P-P-E) or Phase to Phase to Phase fault (P-P-P).

Preferably, when the cable fault is a Phase to Earth fault (P-E) the first marked cable record is made available to the field operative.

Further preferably when the cable fault is a Phase to Phase fault (P-P) or Phase to Phase to Earth fault (P-P-E) or Phase to Phase to Phase fault (P-P-P) the second marked cable record is made available to the field operative.

In use, the power distribution network may be a low voltage (LV) network.

According to a second aspect of the present invention there is provided a fault mapping system for one or more outgoing cables of a power distribution network, comprising:
means for obtaining a geoschematic cable record of the cower distribution network;
means for marking a plurality of intermediate cumulative fault impedance markings adjacent to the route of the one or more cables on the geoschematic cable record for each of the cable branches of the network; and
means for supplying the marked cable record to a field operative having access to an estimated fault impedance of a cable fault, the estimated fault impedance obtained from voltage and current measurements from a single point on the network, wherein the system is configured display fault impedance information, the displayed information being arranged to allow the field operative to compare the estimated fault impedance against the respective plurality of fault impedance markings on the cable branches of the network to locate the cable fault.

According to a third aspect of the present invention there is provided a computer program product for fault mapping of one or more outgoing cables of a power distribution network, the computer program includes instructions, when executed by computer, which perform steps comprising:
obtaining a geoschematic cable record of the power distribution network;
marking a plurality of intermediate cumulative fault impedance markings adjacent to the route of the one or more cables on the geoschematic cable record for each of the cable branches of the network; and
supplying the marked cable record to a field operative having access to an estimated fault impedance of a cable fault, the estimated fault impedance obtained from voltage and current measurements from a single point on the network, wherein the computer program product is configured display fault impedance information, the displayed information being arranged to allow the field operative to compare the estimated fault impedance against the respective plurality of fault impedance markings on the cable branches of the network to locate the cable fault.

According to a fourth aspect of the present invention there is provided a fault mapping method for one or more outgoing cables of a power distribution network, the method comprising the steps of:
obtaining a geoschematic cable record of the power distribution network;
marking a plurality of intermediate cumulative time interval markings adjacent to the route of the one or more cables on the geoschematic cable record for each of the cable branches of the network; and
supplying the marked cable record to a field operative having access to a measured time interval between injection of an investigatory pulse and the return of a reflected pulse from a point of injection on the network, and comparing by the field operative the measured time interval against the respective plurality of time interval markings on the cable branches of the network to locate the cable fault.

Preferably, the step of marking one or more time interval markings adjacent to the route of the one or more cables on the cable record, further comprises the steps of:
selecting a first component of the network having a start point being spaced apart from an end point by a first distance;
determining the propagation velocity of the first component;
calculating one or more time intervals from the determined propagation velocity and the first distance;
marking the one or more time intervals on the cable record adjacent to the first component; and
repeating the selecting, determining, calculating and marking steps for each adjoining component of the network.

Further preferably, the start point is the point of injection on the network.

In use, the step of marking the one or more time intervals on the cable record adjacent to the first and each adjoining component of the network may further comprise displaying cumulative or intermediate time interval markings at a desired resolution from the point of injection on the network and/or from any point of interest.

Preferably, the point of injection is any accessible point of electrical connection to the network and can be selected from the group consisting, but not limited to, any one of the following: busbar in a substation, point of customer connection to the network, a network component or accessory and the like.

According to a sixth aspect of the present invention there is provided a method for fault location on a cable network, the method comprising the steps of:
providing a geoschematic cable record of one or more cables of the cable network, the cable record having fault impedance markings and time interval markings adjacent to the route of the one or more cables of the network;
determining the fault impedance from measured voltage and current measurements from at least one point on the network;
injecting an investigatory pulse into at least one point on the network and measuring the time interval between the injection of the investigatory pulse and the return of a reflected pulse, the determining and injecting steps being in any order; and
marking the measured fault impedance and measured time interval on the one or more cables of the cable network such that congruence between the measured fault impedance and measured time interval determines the location of the fault.

Preferably, the at least one point on the network is the same location for the determining and injecting steps.

Further preferably, the fault on the network corresponds to a measured impedance discontinuity and/or the measured time interval from a discontinuity on a cable network and/or component and/or accessory thereof.

It is believed that a fault mapping method and system for power distribution networks in accordance with the present invention at least addresses the problems outlined above.

It will be obvious to those skilled in the art that variations of the present invention are possible and it is intended that the present invention may be used other than as specifically described herein.

### BRIEF DESCRIPTION OF THE DRAWINGS

The present invention will now be described by way of example only, and with reference to the accompanying drawings, in which:
Figure 1 illustrates a flow diagram showing how a geoschematic representation of a network having one or more fault impedance values superimposed thereon is obtained in accordance with the present invention;
Figure 2 is an example of a phase to earth loop impedance geoschematic of an LV network cable record obtained in accordance with the present invention; and
Figure 3 is an illustrative example of a further embodiment of the invention in which an impedance geoschematic of the cable record can be further marked with Time Domain Reflectometry investigatory data to further pinpoint the fault from a possible number of candidate fault locations on branched networks.

### DETAILED DESCRIPTION OF THE PREFERRED EMBODIMENTS

The present invention has adopted the approach of utilising an impedance-based cable fault mapping method and system for LV networks. Advantageously, the present invention provides means for representing the location of a fault once the fault impedance has been estimated by providing a geoschematic representation of the network having one or more fault impedance values thereon. Since the geoschematic representation of the network has been pre-prepared, once the fault impedance has been estimated, further advantageously the location of the fault can be communicated to field operatives for fault clearing in very short timescales, or in near real time.

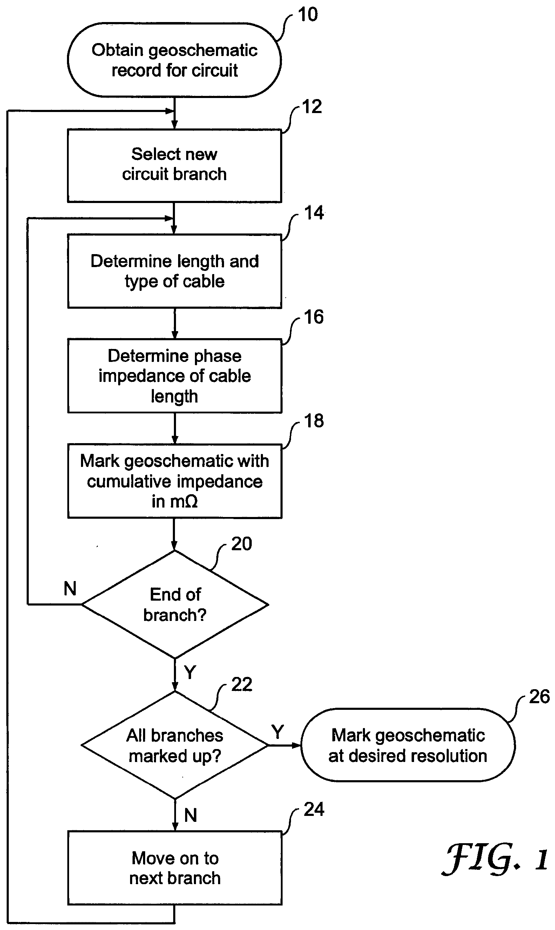

Referring now to the drawings, Figure 1 shows how impedance contoured cable records for a power distribution network are obtained in accordance with the present invention. In the following description each step of Figure 1 will be referred to as "S" followed by a step number, e.g. S10, S12 etc.

The skilled person will appreciate that there are four types of fault that can occur on three-phase LV networks, and which can be all be detected and classified using a variety of impedance-based measurement techniques that are known in the art. In summary, these four types of fault are:

### i) Phase to Earth faults (P-E)

With this type of fault, any one phase makes connection to earth.

### ii) Phase to Phase faults (P-P)

With this type of fault, a connection is established between two phases.

### iii) Phase to Phase to Earth faults (P-P-E)

This fault type involves two phases being connected to earth.

### iv) Phase to Phase to Phase faults (P-P-P)

Finally, all three phases make connection. Whilst it is possible to have a Phase to Phase to Phase to Earth fault, for balanced three-phase networks the contribution of the fault current to the earth return path can be neglected and this fault case can be adequately represented by a Phase to Phase to Phase fault.

The determination of the impedance along a phase conductor on a phase involved in a fault can be determined for all but the Phase to Earth fault. Thus, the determination of fault location can be realised by a cable record having contours showing phase conductor impedance at regular impedance intervals. For example, it has been found that 5mΩ to 20mQ increments provides a suitable resolution for most LV cables commonly used in the United Kingdom. This is in no way intended to be limiting.

For Phase to Earth faults, the phase conductor impedance (or resistance) cannot be easily separated from the impedance (or resistance) of the earth return path of the fault current. For most UK LV cable networks, this return impedance is approximately equivalent to the impedance (or resistance) of the cable neutral. For most cable types in common use, the impedance of the neutral is similar to the impedance of the phase conductor leading to a simplification of the method by using half the Phase to Earth loop impedance and assuming that this equivalent to the phase impedance to the fault. This latter value is suitable for reference against the contoured cable record showing phase conductor impedance at regular impedance intervals, however, the equivalence of earth return impedance to phase impedance over a given length of cable does not hold true for all cable types.

The present invention therefore proposes that two pre-prepared impedance contoured maps can be offered to a field operative following the notification of a fault event and calculation of the fault impedance:
For i) Phase to Earth faults, the phase to earth loop impedance (or resistance) is offered as the fault impedance (or resistance) and an operative is directed to a loop impedance (or resistance) contour cable record.

For all other faults, identified as faults ii) to iv) above, the phase conductor fault impedance (or resistance) is offered as the fault impedance and an operative is directed to a phase conductor impedance (or resistance) contour map.

The steps of preparing such impedance contoured cable records for a particular power distribution network or circuit are illustrated in Figure 1. The first step, at S10, involves obtaining a geoschematic cable record for the particular circuit for which the fault impedance and fault type can be determined. The term "geoschematic cable record" shall be understood to cover the records of a particular power distribution network. This extends not only to the branches of the network in terms of their location and specific route, size and type of cable, burial depth, etc. In the United Kingdom, the distribution network operators generally maintain such geoschematic cable records for their network. The method described herein applies to the use of geoschematic cable records utilised by fault teams in fault location and management work as provided by network operators to those fault teams. The impedance contoured cable records obtained by the present invention, may be a scaled "spider" diagram, a digitised cable record from a graphical information system (superimposed, or not, upon a mapping layer) or some other geoschematic means or graphical layer which conveys the cable routes leading away from a substation.

Having obtained the geoschematic cable record for the particular circuit, at S12, a branch of the circuit is selected. A branch is any series of continuous, connected cable sections on the circuit under consideration that end at different points. A cable section therefore being a determinable length of cable between joints or terminations.

S14 then involves determining the length and type of cable for the section of the branch under consideration starting at the substation outgoing feeder.

Using the cable data obtained at S14, the phase impedance of the cable section under consideration is determined at S16. Cable data pertaining to specific cable types is available from the cable manufacturer, or data tables such as those in the United Kingdom's Energy Networks Association (ENA) Engineering Recommendation P13/1. The applicable data for the calculation being the AC phase and neutral resistance and reactance under operating conditions.

At S18, the geoschematic cable record is marked at the end of the cable section with the cumulative impedance from the substation in mΩ.

At S20, a check is made to ensure that the end of the particular circuit branch has been reached. If there are any further braches of the circuit, the process is returned to S14 to then determine the length and type of cable for the next section of the branch, as illustrated in Figure 1.

When the end of the particular branch of the circuit has been reached at S20, the method, at S22, involves checking that all circuit branches been marked up with the cumulative impedance. If not, at S24, the next circuit branch is selected and the process repeated until the impedance contoured geoschematic cable record is completed for all of the outgoing feeders.

If the outcome of S22 is positive, at S26, for longer cable sections, the geoschematic cable records are marked up using the calculated intermediate cumulative impedances from the substation such that the maximum impedance between markings is set to the desired resolution or increment. The applicant has found that it is particularly useful to mark the intermediate cumulative impedances at the joint positions that mark the transition of one cable section to another. In practice, joints are often good candidates for the location of a fault. The applicant has further found that 20mΩ is a maximum graduation between markings on the geoschematic cable record for interpretation of cable fault location using loop impedance (and correspondingly 10mΩ increments for phase impedance). However, intermediate graduations can also be applied at greater or lesser resolution, as is required.

The methodology set out in Figure 1 is then repeated on a new cable geoschematic (or graphical layer) this time marking up the phase to neutral loop impedance. As noted above, for Phase to Earth faults, the fault impedance will generally be calculated as a loop impedance. For other fault types, the phase impedance is calculated. Whilst often the loop impedance will be twice the phase impedance, this is not always the case, requiring both geoschematic diagrams to be made available.

Both the pre-prepared phase and loop impedance contoured cable records can then be made available to field operatives who will be sent the fault calculations determined by fault impedance values and fault type such that the area, or areas for branched networks, can be identified to allow for rapid fault location. By offering two pre-prepared cable route diagrams with superimposed fault-impedance contours (or location points) such that an operative, once given a fault impedance value and the fault type, can identify the area (or indeed, for branched networks, areas) of the network to which they pertain without any processing delay whatsoever.

It is envisaged that such impedance contoured cable records can be accessed by the field operative from the same source as the fault record is communicated, which often is a web-based portal pushing electronic notifications to mobile electronic communicating devices, without the requirement for a fault location in meters from the substation or post-fault, one-off analysis, as is known in the art.

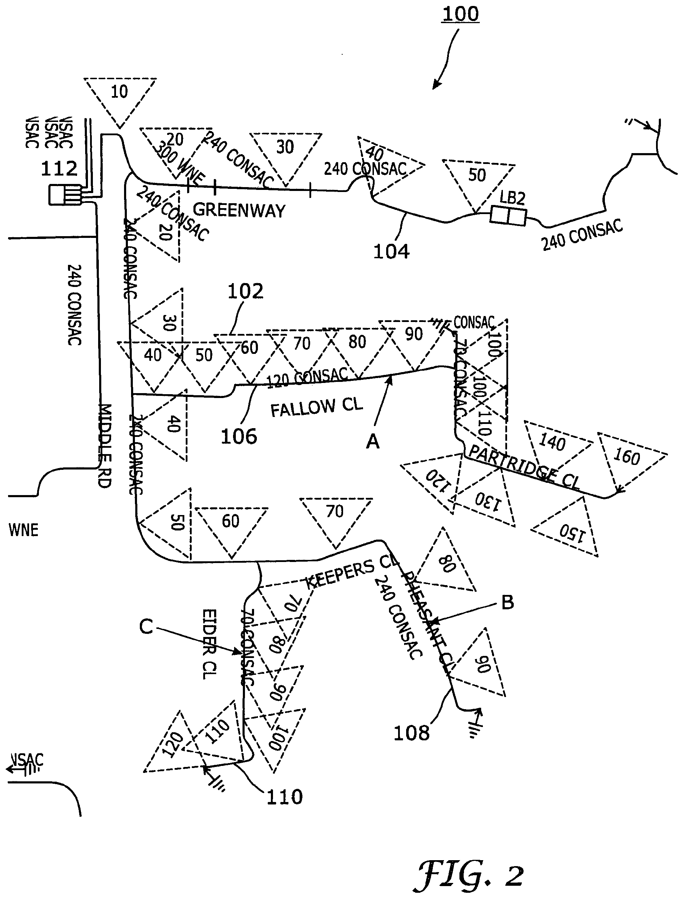

Figure 2 shows an example of a phase to earth loop impedance plan superimposed on a LV network geoschematic cable record 100. Figure 2 shows loop impedance contours or markings 102 having 10mQ increments on the various branches 104, 106, 108, 110 of the network fed by substation 112. If, as in this example, the type of fault encountered was a Phase to Earth fault and the measured loop fault impedance was 85mΩ, then the field operative having access to the pre-prepared contoured cable records described herein would then be able to isolate the fault location to three areas, denoted A, B and C, on branches 106, 108, 110, respectively. Further pinpointing of the cable fault would then be envisaged to precisely locate the fault and clear it as soon as possible.

The advantage of such an approach allows the information communicated from the substation to be instantly and automatically converted into information which can be instantly and automatically transmitted to the field operatives to allow them to determine location without the need for further cable data (or use of a bureau). A field operative with access to the geoschematic diagram with superimposed fault location contours can instantly pinpoint the fault location from information provided in text (namely, the type of fault and impedance). This information is generated and transmitted automatically from the fault location system via text message or e-mail to target recipients in a very short time frame following the fault occurring.

The present invention also allows the use of other information such as recorded (measured) earth loop impedance measurements pertaining to other geographic points on the network. By using several nodes and analysing the differences or imbalances between them, the fault can be located more precisely. These measured earth loop impedance values could be provided via third parties engaged in new service installations or repair on customer's installations, or from the network operators with measurements of, for example, street lighting circuits. Even with access to limited or incomplete cable records further information can be collected via earth loop impedance values and which can be compared with the fault impedance to improve precision.

Therefore, the method according to the present invention which involves mapping the network directly in impedance values or contours therefore allows a fault to be located rapidly and reliably from the estimated fault impedance.

The fault mapping methodology of the present invention can further be extended to other known detection techniques for locating faults in power distribution networks, and Time Domain Reflectometry (TDR) is a recognised method for determining the location of faults on power distribution networks. With such known TDR methods, a DC electrical pulse is injected into a cable at a known point which propagates away from the point of injection and is reflected by points in the cable at which there is a material change in impedance. This includes points at which there is a fault. The reflected pulse can be measured at the point of injection or at a point very close to the point of injection. Provided that the velocity of propagation of the pulse in the cable is known, then the time interval between injection of the pulse and the return of the reflected pulse can be converted to a distance, enabling the position of the fault to be located. The problem of discriminating between faults and other points of reflection in a physically compact device is addressed in co-pending UK Patent Application No. 1810131.1 entitled "A SYSTEM AND METHOD FOR LOCATING FAULTS ON AN ELECTRICITY NETWORK", filed on 20 June 2018 by EA Technology Limited.

In practice, the velocity of propagation of the pulse can vary between different sections of the cable, because the sections may be constructed from different materials, for example oil impregnated paper insulation or polymeric insulation, or have different geometries, in orientation and/or separation of conductors. Additionally the presence of joints and other cable accessories can change the velocity of propagation. Consequently, the practical application of TDR and interpretation of results is a highly-skilled task which often requires the operative to have a great deal of experience in order to produce a reliable fault location. This is particularly the case when the pulse is injected into the whole switchboard to detect transitory and intermittent faults.

The applicant of the present invention has recognised that the speed and accuracy of TDR fault location can also be significantly improved by analysing cable records and making calculations in order to convert the spatial representation of a cable network to a time representation of the same cable network. This is achieved by calculating the propagation velocity of every component in the cable network of interest and combining these in order to determine the time interval which would be observed between any point of injection of the pulse and the return of the reflected pulse from every point of interest in the cable network.

Very much like the impedance fault mapping method and system described herein, the results of this TDR calculation can most usefully be represented as a series of contours of equal time from a given point on the network.

The given point can most usefully be a practical point of electrical connection of the TDR device to the cable network, such as, for example, a busbar in a substation, or a point of customer connection to the cable network. When the location of the injection point is common for multiple fault location events, a single contoured plan can be drawn up for field operatives who are then able to utilise subsequent TDR timing results for fault location on the same network.

A second embodiment of the present invention can therefore be described. The construction and operation of the second embodiment is very similar to that of the first embodiment, but the second embodiment differs from the first embodiment in that instead of representing fault impedance markings or contours on the cable record, one or more time contours are instead included on the cable record, for subsequent fault location.

In a practical embodiment, the operative would: connect the TDR device; inject the signal; measure the time interval between injection of the pulse and the return of the reflected pulse; and compare the measured time interval with the time contour representation of the cable network from the point of injection.

The points on the cable network where a time contour has the same value as the measured time are therefore candidates for the location of the fault. If there is only one such point then the fault has been located. If there is more than one such point then other methods can be applied to discriminate between the candidate points. These methods can include switching network elements on or off to change the topology of the network (if possible); or deployment of more localised methods for locating a fault, for example sampling gases from the ground above a cable at discrete points close together, and identifying the point of highest fault gas concentration (a popular handheld instrument for detection of cable fault gases is the CableSniffer^{™} device available from EA Technology Limited); or excavating at each candidate location and observing and/or physically testing the cable at that point.

As mentioned, if there is more than one point on the cable network where a time contour has the same value as the measured time reflection then there is more than one candidate position for the location of the fault, and it is often undesirable to switch a network. The disadvantage of deploying more localised methods for locating a fault, in order to differentiate between candidate positions, is that they require further time and skilled human resource.

In complex practical networks it is highly likely that there will be a number of points on the network for which the cable circuit and associated accessories between that point and the point of measurement of impedance have the same impedance. It is also highly likely that there will be a number of points on the network for which the cable circuit and associated accessories between that point and the point of TDR injection and measurement of the reflected pulse have the same time interval.

The present invention can therefore further be implemented using a combination of impendence contouring and TDR contouring methodologies which will provide an incredibly accurate determination of the fault location on complicated branched cable networks.

Combining the results of the impedance representation of the cable network and the time representation of the network can usefully reduce the number of candidates for the location of the fault. This is because different, albeit related, physical properties of the cable circuit and associated accessories are responsible for the magnitude of the impedance and of the velocity of propagation of the TDR pulse. The probability of co-location of the candidate points from each method is low, except at the point where the fault is actually located. This is a consequence of using two independent methods of measurement of location.

Usefully the combination of the results of the impedance calculation and the time interval calculation can be represented as a series of different contours, one of equal impedance from a given point on the network, the other of equal time from a given point on the network.

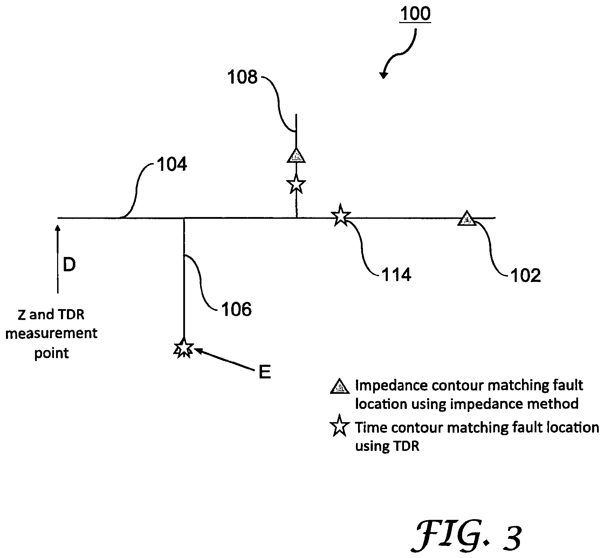

Figure 3 is illustrative of a third embodiment of the invention. The construction and operation of the third embodiment is very similar to that of the first and second embodiments and corresponding features have been given the same reference numerals. The third embodiment of the invention comprises a combinational methodology using both the estimated fault impedance and time reflection contours marked on the cable record. Figure 3 shows a simplified illustrative branched cable record 100 having various cable branches 104, 106, 108 in which the impedance contour representation of the fault has been mapped as a triangle 102 on each of the branches 104, 106, 108. A star 114 shows the location of the fault on the branches 104, 106, 108 as obtained from TDR measurements. Figure 3 shows that the TDR measurement point D is the same location as the impedance measurement point, and in most practical instances they will be the same location. However, they could in some cases be obtained from different locations and this is not intended to be limiting. In this example, the congruence of the results at location E in branch 106 would be a firm indicator that the cable circuit fault is at location E.

In a practical application, the operative would: connect the impedance measuring device and measure the impedance to fault; connect the TDR device; inject the signal; measure the time interval between injection of the pulse and the return of the reflected pulse; compare the measured impedance with the impedance contour representation of the cable network from the point of measurement; and compare the measured time interval with the time contour representation of the cable network from the point of injection. The point at which the impedance contour which has the same value as the measured impedance crosses the time contour which has the same value as the measured time, is the position of the fault.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in the terms of a means for performing the disclosed function, or a method or process for attaining the disclosed result, as appropriate, separately, or in any combination of such features, can be utilised for realising the invention in diverse forms thereof.

The invention is not intended to be limited to the details of the embodiments described herein, which are described by way of example only. It will be understood that features described in relation to any particular embodiment can be featured in combination with other embodiments.

It is contemplated by the inventor that various substitutions, alterations, and modifications may be made to the invention without departing from the scope of the invention as defined by the claims.

## Claims

1. A fault mapping method for one or more outgoing cables of a power distribution network, the method comprising the steps of:
obtaining a geoschematic cable record (100) of the power distribution network;
marking a plurality of intermediate cumulative fault impedance markings (102) adjacent to the route of the one or more cables on the geoschematic cable record for each of the cable branches (104, 106, 108, 110) of the network; and
supplying the marked cable record to a field operative having access to an estimated fault impedance of a cable fault, the estimated fault impedance being obtained from voltage and current measurements from a single point on the network, and comparing by the field operative the estimated fault impedance against the respective plurality of fault impedance markings on the cable branches of the network to locate the cable fault.

2. The method as claimed in claim 1, wherein the marked cable record is a geoschematic cable record which conveys data representative of the one or more cables of the network, the data being selected from the group consisting of any one of the following: individual branches of the network and the location and route of the branches, size and type of cables, cable burial depth, cable joints, substations, circuit protection devices and ratings, link boxes, reclose units, fault management and monitoring devices, road and street names and the like, and/or optionally
wherein the marked cable record is a scaled spider diagram and/or digitised cable record from a graphical information system and/or mapping layer and/or some other geoschematic or graphical layer.

3. The method as claimed in claim 2, wherein the step of marking the plurality of intermediate cumulative fault impedance markings adjacent to the route of the one or more cables on a geoschematic cable record further comprise the steps of:
selecting one cable branch of the network;
determining the length and type of cable for the branch;
calculating the phase to earth loop impedance of the cable branch based on the preceding step; and
recording a cumulative impedance for the branch on a first marked cable record, and/or optionally
wherein the step of marking the plurality of intermediate cumulative fault impedance markings adjacent to the route of the one or more cables on a cable record further comprises the steps of:
selecting one cable branch of the network;
determining the length and type of cable for the branch;
calculating the phase to neutral loop impedance of the cable branch based on the preceding step; and
recording a cumulative impedance for the branch on a second marked cable record.

4. The method as claimed in claim 3, further comprising the step of:
repeating the steps of selecting, determining, calculating and recording for all of the cable branches of the network, and further comprising the step of:
marking all of the cable branches of the network with intermediate impedance markings at a desired resolution on the first and second marked cable records, wherein the desired resolution of the intermediate impedance markings is between around 5mΩ to around 20mΩ, and
making either of the first and second marked cable records available to the field operative dependent upon the type of cable fault on the network.

5. The method as claimed in claim 1, wherein the step of supplying the marked cable record to a field operative having access to an estimated fault impedance of a cable fault further comprising the step of:
alerting the field operative via a push or in-app notification or alert and/or short message service (SMS) text message and/or e-mail notification to a mobile communications device, and wherein the mobile communications device is selected from the group consisting of any one of the following: smartphone, tablet computer, handheld computer, personal digital assistant, media player, desktop computer, notebook, virtual reality headset, smart watch, and any other digital media consumption device and the like.

6. The method as claimed in claim 1, wherein the plurality of intermediate cumulative fault impedance markings comprise numeric and/or graphical elements,
wherein the field operative compares the estimated fault impedance against the respective plurality of intermediate cumulative fault impedance markings on the cable branches to locate the cable fault,
wherein the estimated fault impedance is obtained from voltage and current measurements of at least one point on the network,
wherein the estimated fault impedance is determined using an impedance-based fault location method, and
wherein the power distribution network is a low voltage (LV) network.

7. The method as claimed in claim 4, wherein the cable fault is a Phase to Earth fault (P-E) or Phase to Phase fault (P-P) or Phase to Phase to Earth fault (P-P-E) or Phase to Phase to Phase fault (P-P-P),
wherein when the cable fault is a Phase to Earth fault (P-E) the first marked cable record is made available to the field operative, and
wherein when the cable fault is a Phase to Phase fault (P-P) or Phase to Phase to Earth fault (P-P-E) or Phase to Phase to Phase fault (P-P-P) the second marked cable record is made available to the field operative.

8. A fault mapping system for one or more outgoing cables of a power distribution network, comprising:
means for obtaining a geoschematic cable record (100) of the power distribution network;
means for marking a plurality of intermediate cumulative fault impedance markings (102) adjacent to the route of the one or more cables on the geoschematic cable record for each of the cable branches (104, 106, 108, 110) of the network; and
means for supplying the marked cable record to a field operative having access to an estimated fault impedance of a cable fault, the estimated fault impedance obtained from voltage and current measurements from a single point on the network, wherein the system is configured display fault impedance information, the displayed information being arranged to allow the field operative to compare the estimated fault impedance against the respective plurality of fault impedance markings on the cable branches of the network to locate the cable fault.

9. A computer program product for fault mapping of one or more outgoing cables of a power distribution network, the computer program includes instructions, when executed by computer, which perform steps comprising:
obtaining a geoschematic cable record (100) of the power distribution network;
marking a plurality of intermediate cumulative fault impedance markings (102) adjacent to the route of the one or more cables on the geoschematic cable record for each of the cable branches (104, 106, 108, 110) of the network; and
supplying the marked cable record to a field operative having access to an estimated fault impedance of a cable fault, the estimated fault impedance obtained from voltage and current measurements from a single point on the network, wherein the computer program product is configured display fault impedance information, the displayed information being arranged to allow the field operative to compare the estimated fault impedance against the respective plurality of fault impedance markings on the cable branches of the network to locate the cable fault.

10. A fault mapping method for one or more outgoing cables of a power distribution network, the method comprising the steps of:
obtaining a geoschematic cable record (100) of the power distribution network;
marking a plurality of intermediate cumulative time interval markings (102) adjacent to the route of the one or more cables on the geoschematic cable record for each of the cable branches (104, 106, 108, 110) of the network; and
supplying the marked cable record to a field operative having access to a measured time interval between injection of an investigatory pulse and the return of a reflected pulse from a point of injection on the network, and comparing by the field operative the measured time interval against the respective plurality of time interval markings on the cable branches of the network to locate the cable fault.

11. The method as claimed in claim 10, wherein the step of marking one or more time interval markings adjacent to the route of the one or more cables on the cable record, further comprises the steps of:
selecting a first component of the network having a start point being spaced apart from an end point by a first distance;
determining the propagation velocity of the first component;
calculating one or more time intervals from the determined propagation velocity and the first distance;
marking the one or more time intervals on the cable record adjacent to the first component; and
repeating the selecting, determining, calculating and marking steps for each adjoining component of the network.

12. The method as claimed in claim 11, wherein the start point is the point of injection on the network,
wherein the step of marking the one or more time intervals on the cable record adjacent to the first and each adjoining component of the network further comprises displaying cumulative or intermediate time interval markings at a desired resolution from the point of injection on the network and/or from any point of interest, and
wherein the point of injection is any accessible point of electrical connection to the network and can be selected from the group consisting of any one of the following: busbar in a substation, point of customer connection to the network, a network component or accessory and the like.

13. A method for fault location on a cable network, the method comprising the steps of:
providing a geoschematic cable record (100) of one or more cables of the cable network, the cable record having fault impedance markings and time interval markings adjacent to the route of the one or more cables of the network;
determining the fault impedance from measured voltage and current measurements from at least one point on the network;
injecting an investigatory pulse into at least one point on the network and measuring the time interval between the injection of the investigatory pulse and the return of a reflected pulse, the determining and injecting steps being in any order; and
marking the measured fault impedance (102) and measured time interval (114) on the one or more cables of the cable network such that congruence between the measured fault impedance and measured time interval determines the location of the fault.

14. The method as claimed in claim 13, wherein the at least one point on the network is the same location for the determining and injecting steps, and/or optionally
wherein the fault on the network corresponds to a measured impedance discontinuity and/or the measured time interval from a discontinuity on a cable network and/or component and/or accessory thereof.

## Patentansprüche

1. Verfahren zur Fehlerortung für ein oder mehrere abgehende Kabel eines Stromverteilungsnetzwerks, wobei das Verfahren die folgenden Schritte umfasst:
Erhalten einer geoschematischen Kabelplans (100) des Stromverteilungsnetzwerks;
Markieren einer Vielzahl von Zwischenmarkierungen der kumulativen Fehlerimpedanz (102) entlang der Route eines oder mehrerer Kabel(s) auf dem geoschematischen Kabelplan für jeden der Kabelzweige (104, 106, 108, 110) des Netzwerks; und
Bereitstellung des markierten Kabelplans für einen Feldoperator, der Zugriff auf eine geschätzte Fehlerimpedanz eines Kabelfehlers hat, wobei die geschätzte Fehlerimpedanz aus Spannung- und Strommessungen an einem einzigen Punkt auf dem Netzwerk ermittelt wurde, und Vergleich der geschätzten Fehlerimpedanz durch den Feldoperator mit den jeweiligen Markierungen der Fehlerimpedanz an den Kabelzweigen des Netzwerks zur Lokalisierung des Kabelfehlers.

2. Verfahren nach Anspruch 1, wobei der markierte Kabelplan ein geoschematischer Kabelplan ist, der Daten übermittelt, die für das eine oder die mehreren Kabel des Netzwerks repräsentativ sind, wobei die Daten aus der Gruppe ausgewählt sind, die aus einem der folgenden Elemente besteht: einzelnen Zweigen des Netzwerks sowie Lage und Route der Zweige, Größe und Typ der Kabel, Verlegungstiefe der Kabel, Kabelverbindungen, Unterstationen, Leitungsschutzvorrichtungen und deren Bemessungswerte, Anschlusskästen, Wiedereinschalteinheiten, Vorrichtungen für Fehlermanagement und Überwachung, Namen von Straßen und Wegen und dergleichen, und/oder optional
wobei es sich bei dem markierten Kabelplan um ein maßstäbliches Spinnendiagramm und/oder einen digitalisierten Kabelplan aus einem grafischen Informationssystem und/oder einer Kartierungsebene und/oder einer sonstigen geoschematischen oder grafischen Ebene handelt.

3. Verfahren nach Anspruch 2, wobei der Schritt des Markierens der Vielzahl von Zwischenmarkierungen für kumulative Fehlerimpedanzen benachbart zur Route des einen oder der mehreren Kabel in einem geoschematischen Kabelplan ferner die folgenden Schritte umfasst:
Auswählen eines Kabelzweiges des Netzwerks;
Bestimmen der Länge und des Typs des Kabels für den Zweig;
Berechnen der Schleifenimpedanz (Phase-Erde) des Kabelzweiges auf der Grundlage des vorherigen Schritts; und
Aufzeichnen einer kumulativen Impedanz für den Zweig in einem ersten markierten Kabelplan und/oder optional
wobei der Schritt des Markierens der Vielzahl von Zwischenmarkierungen für kumulative Fehlerimpedanzen benachbart zur Route des einen oder der mehreren Kabel in einem Kabelplan ferner die folgenden Schritte umfasst:
Auswählen eines Kabelzweiges des Netzwerks;
Bestimmen der Länge und des Typs des Kabels für den Zweig;
Berechnen der Schleifenimpedanz (Phase-Neutralleiter) des Kabelzweiges auf der Grundlage des vorherigen Schritts; und
Aufzeichnen einer kumulativen Impedanz für den Zweig auf einem zweiten markierten Kabelplan.

4. Verfahren nach Anspruch 3, ferner folgenden Schritt umfassend:
Wiederholen der Schritte Auswählen, Bestimmen, Berechnen und Aufzeichnen für alle Kabelzweige des Netzwerks und ferner den folgenden Schritt umfassend:
Markieren aller Kabelzweige des Netzwerks auf den ersten und zweiten markierten Kabelplänen mit Zwischenmarkierungen der Impedanz in der gewünschten Auflösung versehen, wobei die gewünschte Auflösung der Zwischenmarkierungen der Impedanz zwischen etwa 5 mΩ und etwa 20 mΩ liegt, und
Bereitstellung entweder des ersten oder des zweiten markierten Kabelplans für den Feldoperator in Abhängigkeit von der Art des Kabelfehlers im Netzwerk.

5. Verfahren nach Anspruch 1, wobei der Schritt der Bereitstellung des markierten Kabelplans an einen Feldoperator, der Zugriff auf eine geschätzte Fehlerimpedanz eines Kabelfehlers hat, ferner den folgenden Schritt umfasst:
Warnen des Feldoperators mittels einer Push- oder In-App-Benachrichtigung oder eines Alarms und/oder einer SMS-Kurznachricht und/oder einer E-Mail-Benachrichtigung an ein Mobilfunkgerät, wobei das Mobilfunkgerät aus der Gruppe ausgewählt ist, die aus einem der folgenden besteht: Smartphone, Tablet-Computer, Handheld-Computer, Personal Digital Assistent, Mediaplayer, Desktop-Computer, Notebook, Virtual-Reality-Headset, Smartwatch sowie jedes sonstige Gerät zur Nutzung digitaler Medien und dergleichen.

6. Verfahren nach Anspruch 1, wobei die Vielzahl der Zwischenmarkierungen für die kumulative Fehlerimpedanz numerische und/oder grafische Elemente umfasst,
wobei der Feldoperator die geschätzte Fehlerimpedanz mit den jeweiligen Zwischenmarkierungen der kumulativen Fehlerimpedanz an den Kabelzweigen vergleicht, um den Kabelfehler zu lokalisieren,
wobei die geschätzte Fehlerimpedanz aus Spannung- und Strommessungen an mindestens einem Punkt des Netzwerks erhalten wird.
wobei die geschätzte Fehlerimpedanz mithilfe eines auf Impedanz basierten Fehlerortungsverfahrens bestimmt wird, und
wobei das Stromverteilungsnetzwerk ein Niederspannungsnetzwerk (NS-Netzwerk) ist.

7. Verfahren nach Anspruch 4, wobei der Kabelfehler ein Phase-Erde-Fehler (P-E), oder Phase-Phase-Fehler (P-P) oder Phase-Phase-Erde-Fehler (P-P-E) oder Phase-Phase-Phase-Fehler (P-P-P) ist,
wobei, wenn der Kabelfehler ein Phasen-Erde-Fehler (P-E) ist, der erste markierte Kabelplan dem Feldoperator zur Verfügung gestellt wird, und
wobei, wenn der Kabelfehler ein Phase-Phase-Fehler (P-P) oder Phase-Phase-Erde-Fehler (P-P-E) oder Phase-Phase-Phase-Fehler (P-P-P) ist, der zweite markierte Kabelplan dem Feldoperator zur Verfügung gestellt wird.

8. System zur Fehlerortung für ein oder mehrere abgehende Kabel eines Stromverteilungsnetzes, umfassend:
Mittel zum Erlangen eines geoschematischen Kabelplans (100) des Stromverteilungsnetzwerks;
Mittel zum Markieren einer Vielzahl von Zwischenmarkierungen (102) für kumulative Fehlerimpedanzen entlang der Route des einen oder der mehreren Kabel in der geoschematischen Kabeldarstellung für jeden der Kabelzweige (104, 106, 108, 110) des Netzwerks; und
Mittel zur Bereitstellung des markierten Kabelplans für einen Feldoperator, der Zugriff auf eine geschätzte Fehlerimpedanz eines Kabelfehlers hat, wobei die geschätzte Fehlerimpedanz aus Spannung- und Strommessungen an einem einzigen Punkt des Netzwerks ermittelt wurde, wobei das System dazu eingerichtet ist, Informationen zur Fehlerimpedanz anzuzeigen und wobei die angezeigten Informationen so gestaltet sind, dass der Feldoperator die geschätzte Fehlerimpedanz mit der jeweiligen Vielzahl von Markierungen der Fehlerimpedanz an den Kabelzweigen des Netzwerks vergleichen kann, um den Kabelfehler zu lokalisieren.

9. Computerprogrammprodukt zur Fehlerortung an einem oder mehreren abgehenden Kabeln eines Stromverteilungsnetzwerks, wobei das Computerprogramm Anweisungen enthält, die bei Ausführung durch einen Computer Schritte durchführen, welche umfassen:
Erlangen eines geoschematischen Kabelplans (100) des Stromverteilungsnetzwerks;
Markieren einer Vielzahl von Zwischenmarkierungen der kumulativen Fehlerimpedanz (102) entlang der Route eines oder mehrerer Kabel(s) auf dem geoschematischen Kabelplan für jeden der Kabelzweige (104, 106, 108, 110) des Netzwerks; und
Bereitstellung des markierten Kabelplans für einen Feldoperator, der Zugriff auf eine geschätzte Fehlerimpedanz eines Kabelfehlers hat, wobei die geschätzte Fehlerimpedanz aus Spannung- und Strommessungen an einem einzigen Punkt des Netzwerks ermittelt wurde, wobei das Computerprogrammprodukt dazu eingerichtet ist, Informationen zur Fehlerimpedanz anzuzeigen, und wobei die angezeigten Informationen so gestaltet sind, dass der Feldoperator die geschätzte Fehlerimpedanz mit der jeweiligen Vielzahl von Markierungen der Fehlerimpedanz an den Kabelzweigen des Netzwerks vergleichen kann, um den Kabelfehler zu lokalisieren.

10. Verfahren zur Fehlerortung für ein oder mehrere abgehende Kabel eines Stromverteilungsnetzwerks, wobei das Verfahren die folgenden Schritte umfasst:
Erlangen eines geoschematischen Kabelplans (100) des Stromverteilungsnetzwerks;
Markieren einer Vielzahl von Zwischenmarkierungen (102) eines kumulativen Zeitintervalls entlang der Route des einen oder mehrerer Kabel(s) auf dem geoschematischen Kabelplan für jeden der Kabelzweige (104, 106, 108, 110) des Netzwerks; und
Bereitstellung des markierten Kabelplans für einen Feldoperator, der Zugriff auf ein gemessenes Zeitintervall zwischen der Einspeisung eines Prüfimpulses und der Rückkehr eines reflektierten Impulses von einem Einspeisepunkt im Netz hat, und Vergleich des gemessenen Zeitintervalls durch den Feldoperator mit der jeweiligen Vielzahl von Zeitintervallmarkierungen an den Kabelzweigen des Netzwerks zur Ortung des Kabelfehlers.

11. Verfahren nach Anspruch 10, wobei der Schritt des Markierens einer oder mehrerer Zeitintervallmarkierungen entlang der Route des einen oder der mehreren Kabel(s) auf dem Kabelplan ferner die folgenden Schritte umfasst:
Auswählen einer ersten Komponente des Netzwerks, die einen Startpunkt aufweist, der um einen ersten Abstand von einem Endpunkt beabstandet ist;
Bestimmen der Ausbreitungsgeschwindigkeit der ersten Komponente;
Berechnen eines oder mehrerer Zeitintervalle aus der ermittelten Ausbreitungsgeschwindigkeit und der ersten Entfernung;
Markieren des einen oder der mehreren Zeitintervalle auf der Kabelaufzeichnung angrenzend an die erste Komponente; und
Wiederholen der Schritte Auswählen, Bestimmen, Berechnen und Markierens für jede angrenzende Komponente des Netzwerks.

12. Verfahren nach Anspruch 11, wobei der Startpunkt der Einspeisepunkt im Netzwerk ist,
wobei der Schritt des Markierens des einen Zeitintervalls oder der mehreren Zeitintervalle auf dem Kabelplan neben der ersten und jeder angrenzenden Komponente des Netzwerks ferner das Anzeigen kumulativer oder zwischenzeitlicher Intervallmarkierungen in einer gewünschten Auflösung vom Einspeisepunkt im Netzwerk und/oder von einem beliebigen Punkt von Interesse umfasst, und
wobei der Einspeisepunkt ein beliebiger zugänglicher elektrischer Anschlusspunkt an das Netzwerk ist, und aus der Gruppe ausgewählt werden kann, die aus einem der folgenden Elemente besteht: Sammelschiene in einer Unterstation, Kundenanschlusspunkt an das Netzwerk, eine Netzwerkkomponente oder ein Zubehörteil und dergleichen.

13. Verfahren zur Fehlerortung in einem Kabelnetzwerk, wobei das Verfahren die folgenden Schritte umfasst:
Bereitstellen eines geoschematischen Kabelplans (100) eines oder mehrerer Kabel des Kabelnetzwerks, wobei der Kabelplan Markierungen der Fehlerimpedanz und Markierungen der Zeitintervalle aufweist, die an die Route des einen oder der mehreren Kabel des Netzwerks angrenzen;
Bestimmen der Fehlerimpedanz anhand gemessener Spannung und Strommessungen von mindestens einem Punkt im Netzwerk;
Einspeisen eines Prüfimpulses an mindestens einem Punkt des Netzwerks und Messen des Zeitintervalls zwischen dem Einspeisen des Prüfimpulses und der Rückkehr eines reflektierten Impulses, wobei die Schritte der Bestimmung und Einspeisung in beliebiger Reihenfolge erfolgen können; und
Markieren der gemessenen Fehlerimpedanz (102) und des gemessenen Zeitintervalls (114) auf dem einen oder den mehreren Kabel(n) des Kabelnetzwerks derart, dass eine Übereinstimmung zwischen der gemessenen Fehlerimpedanz und dem gemessenen Zeitintervall den Ort des Fehlers bestimmt.

14. Verfahren nach Anspruch 13, wobei der mindestens eine Punkt im Netzwerk für die Bestimmung- und Einspeisungsschritte derselbe Ort ist, und/oder optional
wobei der Fehler im Netzwerk einer gemessenen Diskontinuität der Impedanz und/oder dem gemessenen Zeitintervall ab einer Diskontinuität in einem Kabelnetzwerk und/oder einer Komponente und/oder einem Zubehörteil desselben entspricht.

## Revendications

1. Procédé de cartographie de défauts portant sur un ou plusieurs câbles sortants d'un réseau de distribution d'énergie, le procédé comprenant les étapes consistant à :
obtenir un relevé géo-schématique de câble (100) du réseau de distribution d'énergie ;
marquer une pluralité de repères intermédiaires d'impédance de défaut cumulée (102) à proximité du tracé dudit ou desdits plusieurs câbles sur le relevé géo-schématique de câble pour chacune des ramifications de câble (104, 106, 108, 110) du réseau ; et
remettre le relevé de câble marqué à un opérateur de terrain ayant accès à une impédance de défaut estimée d'un défaut de câble, l'impédance de défaut estimée étant obtenue à partir de mesures de tension et de courant effectuées sur un point unique du réseau, l'opérateur de terrain effectuant alors une comparaison de l'impédance de défaut estimée avec la pluralité respective de repères d'impédance de défaut sur les ramifications de câble du réseau afin de localiser le défaut présent sur le câble.

2. Procédé selon la revendication 1, dans lequel le relevé de câble marqué est un relevé de câble géo-schématique qui transmet des données représentatives dudit ou desdits plusieurs câbles du réseau, les données étant sélectionnées dans le groupe constitué de l'un quelconque des éléments suivants : les ramifications individuelles du réseau ainsi que l'emplacement et le tracé des ramifications, la taille et le type de câbles, la profondeur d'ensouillage des câbles, les épissures de câble, les sous-stations, les dispositifs de protection des circuits et leur calibrage, les boîtes de liaison, les unités de réenclenchement, les dispositifs de gestion et de surveillance des défauts, les noms de routes et de rues et d'éléments analogues ; et/ou facultativement
dans lequel le relevé de câble marqué est un schéma en araignée à l'échelle et/ou un relevé de câble numérisé provenant d'un système d'information graphique et/ou d'une couche de cartographie et/ou de quelque autre couche géo-schématique ou graphique.

3. Procédé selon la revendication 2, dans lequel l'étape de marquage de la pluralité de repères intermédiaires d'impédance de défaut cumulée à proximité du tracé dudit ou desdits plusieurs câbles sur un relevé géo-schématique de câble inclut en outre les étapes consistant à :
sélectionner une ramification de câble du réseau ;
déterminer la longueur et le type de câble auquel correspond la ramification ;
calculer l'impédance de boucle phase-terre de la ramification de câble en se référant à l'étape précédente ; et
consigner une impédance cumulée de la ramification sur un premier relevé de câble marqué, et/ou facultativement
dans lequel l'étape de marquage de la pluralité de repères intermédiaires d'impédance de défaut cumulée à proximité du tracé dudit ou desdits plusieurs câbles sur un relevé de câble inclut en outre les étapes consistant à :
sélectionner une ramification de câble du réseau ;
déterminer la longueur et le type de câble auquel correspond la ramification ;
calculer l'impédance de boucle phase-neutre de la ramification de câble en se référant à l'étape précédente ; et
consigner une impédance cumulée de la ramification sur un second relevé de câble marqué.

4. Procédé selon la revendication 3, comprenant en outre l'étape consistant à :
répéter les étapes de sélection, de détermination, de calcul et d'enregistrement de toutes les ramifications de câble du réseau, et comprenant en outre l'étape consistant à :
marquer toutes les ramifications de câble du réseau avec des repères d'impédance intermédiaires à une résolution souhaitée sur les premier et second relevés de câbles marqués, dans lequel la résolution souhaitée des repères d'impédance intermédiaires se situe entre 5 mΩ et 20 mΩ environ, et
mettre l'un ou l'autre des premier et second relevés de câble marqués à la disposition de l'opérateur de terrain, selon le type de défaut de câble présent sur le réseau.

5. Procédé selon la revendication 1, dans lequel l'étape de remise du relevé de câble marqué à un opérateur de terrain ayant accès à une impédance de défaut estimée d'un défaut de câble comprend en outre l'étape consistant à :
alerter l'opérateur de terrain soit par notification ou alerte push soit par notification ou alerte intégrée à une application et/ou envoi d'un message texte de service de messages courts (SMS) et/ou par notification par courrier électronique sur un dispositif de communication mobile, et dans lequel le dispositif de communication mobile est sélectionné dans le groupe constitué de l'un quelconque des dispositifs suivants : smartphone, tablette, ordinateur de poche, assistant numérique personnel, lecteur multimédia, ordinateur de bureau, ordinateur portable, casque de réalité virtuelle, montre intelligente et tout autre dispositif de consommation de médias numériques et autres dispositifs analogues.

6. Procédé selon la revendication 1, dans lequel la pluralité de repères intermédiaires d'impédance de défaut cumulée comprend des éléments numériques et/ou graphiques,
dans lequel l'opérateur de terrain effectue une comparaison de l'impédance de défaut estimée avec la pluralité respective de repères intermédiaires d'impédance de défaut cumulée sur les ramifications de câble afin de localiser le défaut présent sur le câble,
dans lequel l'impédance de défaut estimée est obtenue à partir de mesures de tension et de courant effectuées sur un point unique du réseau,
dans lequel l'impédance de défaut estimée est déterminée en faisant appel à un procédé de localisation de défaut basé sur l'impédance, et
dans lequel le réseau de distribution d'énergie est un réseau basse tension (BT).

7. Procédé selon la revendication 4, dans lequel le défaut de câble est un défaut Phase-Terre (P-E) ou un défaut Phase-Phase (P-P) ou une défaut Phase-Phase-Terre (P-P-E) ou un défaut Phase-Phase-Phase (P-P-P),
dans lequel, lorsque le défaut de câble est un défaut Phase-Terre (P-E), le premier relevé de câble marqué est mis à la disposition de l'opérateur de terrain, et
dans lequel, lorsque le défaut de câble est un défaut Phase-Phase (P-P) ou un défaut Phase-Phase-Terre (P-P-E) ou un défaut Phase-Phase-Phase (P-P-P), le second relevé de câble marqué est mis à la disposition de l'opérateur de terrain.

8. Système de cartographie de défauts portant sur un ou plusieurs câbles sortants d'un réseau de distribution d'énergie, comprenant :
des moyens permettant d'obtenir un relevé de câble géo-schématique (100) du réseau de distribution d'énergie ;
des moyens permettant de marquer une pluralité de repères intermédiaires d'impédance de défaut cumulée (102) à proximité du tracé dudit ou desdits plusieurs câbles sur le relevé géo-schématique de câble pour chacune des ramifications de câble (104, 106, 108, 110) du réseau ; et
des moyens permettant de remettre le relevé de câble marqué à un opérateur de terrain ayant accès à une impédance de défaut estimée d'un défaut de câble, l'impédance de défaut estimée étant obtenue à partir de mesures de tension et de courant effectuées sur un point unique du réseau, dans lequel le système est configuré pour afficher des informations sur l'impédance de défaut, les informations affichées étant agencées pour permettre à l'opérateur de terrain d'effectuer une comparaison de l'impédance de défaut estimée avec la pluralité respective de repères d'impédance de défaut sur les ramifications de câble du réseau pour localiser le défaut présent sur le câble.

9. Produit-programme informatique pour cartographier des défauts sur un ou plusieurs câbles sortants d'un réseau de distribution d'énergie, le programme informatique intégrant des instructions qui, lorsqu'elles sont exécutées par l'ordinateur, effectuent des étapes consistant à :
obtenir un relevé géo-schématique de câble (100) du réseau de distribution d'énergie ;
marquer une pluralité de repères intermédiaires d'impédance de défaut cumulée (102) à proximité du tracé dudit ou desdits plusieurs câbles sur le relevé géo-schématique de câble pour chacune des ramifications de câble (104, 106, 108, 110) du réseau ; et
remettre le relevé de câble marqué à un opérateur de terrain ayant accès à une impédance de défaut estimée d'un défaut de câble, l'impédance de défaut estimée étant obtenue à partir de mesures de tension et de courant effectuées sur un point unique du réseau, dans lequel le produit-programme informatique est configuré pour afficher des informations sur l'impédance de défaut, les informations affichées étant agencées pour permettre à l'opérateur de terrain d'effectuer une comparaison de l'impédance de défaut estimée avec la pluralité respective de repères d'impédance de défaut sur les ramifications de câble du réseau pour localiser le défaut présent sur le câble.

10. Procédé de cartographie de défauts portant sur un ou plusieurs câbles sortants d'un réseau de distribution, le procédé comprenant les étapes consistant à :
obtenir un relevé géo-schématique de câble (100) du réseau de distribution d'énergie ;
marquer une pluralité de repères intermédiaires d'impédance de défaut cumulée (102) à proximité du tracé dudit ou desdits plusieurs câbles sur le relevé géo-schématique de câble pour chacune des ramifications de câble (104, 106, 108, 110) du réseau ; et
remettre le relevé de câble marqué à un opérateur de terrain ayant accès à un intervalle de temps mesuré entre l'injection d'une impulsion d'investigation et le retour d'une impulsion réfléchie depuis un point de d'injection sur le réseau, et procéder à une comparaison par l'opérateur de terrain de l'intervalle de temps mesuré avec la pluralité respective de repères d'intervalle de temps sur les ramifications de câble du réseau pour localiser le défaut présent sur le câble.

11. Procédé selon la revendication 10, dans lequel l'étape de marquage d'un ou de plusieurs repères d'intervalle de temps à proximité du tracé dudit ou desdits câbles sur le relevé de câble, comprend en outre les étapes consistant à :
sélectionner un premier composant du réseau dont un point de départ est espacé d'un point d'extrémité selon une première distance ;
déterminer la vitesse de propagation du premier composant ;
calculer un ou plusieurs intervalles de temps à partir de la vitesse de propagation déterminée et de la première distance ;
marquer ledit ou lesdits plusieurs intervalles de temps sur le relevé de câble à proximité du premier composant ; et
répéter les étapes de sélection, de détermination, de calcul et de marquage pour chaque composant attenant du réseau.

12. Procédé selon la revendication 11, dans lequel le point de départ est le point d'injection sur le réseau,
dans lequel l'étape de marquage dudit ou desdits plusieurs intervalles de temps sur le relevé de câble à proximité du premier et de chaque composant attenant du réseau consiste en outre à afficher des repères d'intervalle de temps cumulés ou intermédiaires à une résolution souhaitée depuis le point d'injection sur le réseau et/ou depuis tout point d'intérêt, et
dans lequel le point d'injection est n'importe quel point de connexion électrique accessible au réseau et qui peut être sélectionné dans le groupe constitué d'un des éléments suivants : une barre omnibus dans une sous-station, un point de raccordement client au réseau, un composant ou un accessoire de réseau et un élément analogue.

13. Procédé de localisation de défaut sur un réseau de câbles, le procédé comprenant les étapes consistant à :
fournir un relevé géo-schématique de câble (100) d'un ou de plusieurs câbles du réseau de câbles, le relevé de câble comportant des repères d'impédance de défaut et des repères d'intervalle de temps à proximité du tracé dudit ou desdits plusieurs câbles du réseau ;
déterminer l'impédance de défaut à partir de mesures de tension et de courant effectuées depuis au moins un point sur le réseau ;
injecter une impulsion d'investigation dans au moins un point sur le réseau et mesurer l'intervalle de temps écoulé entre l'injection de l'impulsion d'investigation et le retour d'une impulsion réfléchie, les étapes de détermination et d'injection ayant lieu dans un ordre quelconque, et
marquer l'impédance de défaut mesurée (102) et l'intervalle de temps mesuré (114) sur ledit ou lesdits plusieurs câbles du réseau de câbles, de sorte que la concordance entre l'impédance de défaut mesurée et l'intervalle de temps mesuré détermine l'emplacement du défaut.

14. Procédé selon la revendication 13, dans lequel le au moins un point sur le réseau est localisé au même endroit en ce qui concerne les étapes de détermination et d'injection, et/ou facultativement
dans lequel le défaut présent sur le réseau correspond à une discontinuité de l'impédance mesurée et/ou à l'intervalle de temps mesuré en raison d'une discontinuité sur un réseau de câbles et/ou sur un composant et/ou sur un accessoire de ce dernier.
